# EUROPÄISCHE PATENTANMELDUNG

(11) **EP 2 148 557 A2**
(43) Veröffentlichungstag der Anmeldung: **27.01.2010**
(21) Anmeldenummer: 09008702.4
(22) Anmeldetag: 03.07.2009
(51) Int. Cl.: H05K 7/10

(54) **Anordnung mit einem Leistungshalbleitermodul und mit einer Verbindungseinrichtung**

(30) Priorität: 24.07.2008 DE 102008034467
(71) Anmelder: Semikron Elektronik GmbH & Co. KG Patentabteilung, 90431 Nürnberg (DE)
(72) Erfinder: Knebel, Markus, 90587 Tuchenbach (DE)

(57) **Zusammenfassung**

Anordnung in Druckkontaktierung mit einem Leistungshalbleitermodul und mit einer Verbindungseinrichtung, wobei das Leistungshalbleitermodul ein Gehäuse und ein erstes Kontaktelement und ein ihm zugeordnetes ersten Widerlager aufweist. Hierbei ist das erste Kontaktelement aus einer alternierenden Schichtfolge aus mindestens einer ersten in sich strukturierten und somit Leiterbahnen ausbildenden Schicht und mindestens einer isolierenden Schicht ausgestaltet und weist mindestens einen ersten, aus einer an einer Außenseite des Gehäuses angeordneten Durchführung im Gehäuse reichenden Kontaktabschnitt zur Kontaktierung mit der Verbindungseinrichtung auf.

Die Verbindungseinrichtung weist einen Isolierstoffformkörper, mindestens ein zweites Kontaktelement und ein ihm zugeordnetes zweites Widerlager auf, wobei das dem Isolierstoffformkörper zugeordnete mindestens eine zweite Kontaktelement einen zweiten Kontaktabschnitt zur Kontaktierung mit dem ersten Kontaktabschnitt des ersten Kontaktelements und einen dritten Kontaktabschnitt zur Kontaktierung mit einer externen Leiterplatte aufweist Weiterhin ist mindestens ein Kontaktabschnitt gegenüber dem ihm zugeordneten Widerlager federnd ausgestaltet.

## Beschreibung

Die Erfindung beschreibt eine Anordnung in Druckkontaktierung mit einem kompakten Leistungshalbleitermodul mit einem Kontaktelement zur elektrischen Verbindung der Last- und Steueranschlüsse von Leistungshalbleiterbauelementen und mit einer Verbindungseinrichtung zur Verbindung des Kontaktelements mit einer externen Leiterplatte. Hierbei soll im Folgenden mit dem Begriff der Lastverbindung eine Verbindung zwischen einer Kontakteinrichtung des Leistungshalbleitermoduls und einem externen Leitungselement verstanden werden, wobei hiermit die Lastanschlüsse, also beispielhaft in einer Halbbrückenschaltung die Gleichstromeingänge vom Zwischenkreis sowie der Wechselstromausgang, verstanden werden.

Analog wird mit Steuerverbindung im Folgenden die Verbindung eines Hilfs- bzw. Steueranschlusses des Leistungshalbleitermoduls mit einem externen Steueranschlusselements verstanden. Hierunter sind weiterhin Sensorverbindungen des Leistungshalbleitermoduls zu subsumieren.

Einen Ausgangspunkt der Erfindung bilden Leistungshalbleitermodule, wie sie beispielhaft aus der DE 10 2004 025 609 A1, oder der DE 103 55 925 A1 bekannt sind. Erstgenannte Druckschrift offenbart ein Leistungshalbleitermodul in Schraub-Druckkontaktierung. Die Lastverbindung des Leistungshalbleitermoduls mit einer Leiterplatte wird hierbei mittels einer Schraubverbindung nach dem Stand der Technik erreicht. Die Steuerverbindungen der Hilfs- bzw. Steueranschlüsse sind hierbei ausgebildet als Verbindung zwischen einem Federkontaktelemente und einem Leiterbahnabschnitt der Leiterplatte. Erfindungsgemäß erfolgt die Druckeinleitung auf die Steuerverbindung durch die Anordnung und Verschraubung der Leiterplatte mit den Lastanschlusselementen. Die Ausgestaltung eines Leistungshalbleitermoduls in der genannten Art ist besonders geeignet für Strombelastungen jenseits von 10 Ampere.

Die DE 103 55 925 A1 offenbart ein Kontaktelement für Leistungshalbleiterbauelemente bestehend aus einem Folienverbund einer ersten und einer zweiten leitenden Folie mit einer isolierenden Zwischenlage. Die Leistungshalbleiterbauelemente sind mit der ersten leitenden Schicht mittels Ultraschallschweißen dauerhaft sicher elektrisch verbunden. Die modulinterne schaltungsgerechte Verbindung der Leistungshalbleiterbauelement, die sowohl Last- als auch Steueranschlüsse beinhaltet ist hier offengelegt. Allerdings offenbart die genannte Druckschrift keine Details der Last- und Steuerverbindungen zur externen Anbindung.

Die DE 10 2006 078 013 A1 offenbart ein Leistungshalbleitermodul mit einem Gehäuse, einem Substrat und dem als der DE 103 55 925 A1 bekannten Kontaktelement als Folienverbund, wobei der Folienverbund in einzelnen definierten Abschnitten durch Führungsabschnitte im Gehäuse an die Außenseite des Gehäuses reicht, um dort Last- und Steueranschlüsse mit einer externen Leiterplatte zu gewährleisten. Nachteilig ist hierbei, dass die Kontaktierung der Last- und Steueranschlüsse gemäß dem Stand der Technik keine Toleranzen bezüglich mechanischer Stressbelastung oder Wärmeausdehnung erlaubt.

Der Erfindung liegt die Aufgabe zugrunde, eine Anordnung in Druckkontaktierung mit einem Leistungshalbleitermodul mit einem als alternierende Schichtfolge ausgestalteten Kontaktelement und einer Verbindungseinrichtung zur elektrisch leitenden Verbindung mit einer externen Leiterplatte vorzustellen, wobei diese Anordnung einfach herzustellen ist, eine zuverlässige, jederzeit lösbare Kontaktierung der Last- und Steueranschlüsse zwischen Leistungshalbleitermodul und externer Leiterplatte aufweist und diese Kontaktierung tolerant gegenüber mechanischer Stressbelastung und/oder Wärmeausdehnung ausgestaltet ist.

Die Aufgabe wird erfindungsgemäß gelöst, durch die Maßnahmen der Merkmale des Anspruchs 1. Bevorzugte Ausführungsformen sind in den Unteransprüchen beschrieben.

Der erfinderische Gedanke geht aus von einer Anordnung mit einem Leistungshalbleitermodul und mit einer Verbindungseinrichtung zur Verbindung mit einer externen Leiterplatte.

Das Leistungshalbleitermodul weist hierbei ein Gehäuse, mindestens ein Substrat mit Leiterbahnen und auf diesen Leiterbahnen schaltungsgerecht angeordnete Leistungshalbleiterbauelemente auf. Weiterhin weist das Leistungshalbleitermodul mindestens ein erstes Kontaktelement auf, wobei dieses aus einer alternierenden Schichtfolge als mindestens einer ersten leitenden Schicht und mindestens einer isolierenden Schicht besteht. Die mindestens eine leitende Schicht ist in sich strukturiert und bildet somit zweite Leiterbahnen aus, welche die Last- und Steueranschlussflächen der Leistungshalbleiterbauelemente schaltungsgerecht kontaktieren.

Das Kontaktelement wird mittels im Gehäuse angeordneten ersten Führungsabschnitten aus dem Inneren des Leistungshalbleitermoduls an die Außenseite des Gehäuses geführt und bildet an der Außenseite des Gehäuses ab dem Austritt aus der Durchführung im Gehäuse einen ersten Kontaktabschnitt aus. Weiterhin ist dem Kontaktelement an seinem ersten Kontaktabschnitt ein erstes Widerlager zugeordnet, für die in der Druckkontaktierung auftretenden Auflagekräfte auf den ersten Kontaktabschnitt des Kontaktelements. Dieses Widerlager ist bevorzugt einstückig aus dem Gehäusematerial ausgebildet.

Die Verbindungseinrichtung weist einen Isolierstoffformkörper und mindestens ein zweites elektrische leitendes Kontaktelement auf, mit einem ihm zugeordneten zweiten Widerlager. Das zweite Kontaktelement führt in zweiten und dritten Kontaktabschnitten von einer ersten Hauptfläche des Isolierstoffformkörpers durch einen im Isolierstoffformkörper angeordneten zweiten Führungsabschnitt an die zweite Hauptfläche des Isolierstoffformkörpers und bildet dort die schaltungsgerechte Verbindung mit der externen Leiterplatte aus. Hierbei definiert sich der zweite Kontaktabschnitt als der dem Leistungshalbleitermodul zugewandte Abschnitt bis zum Eintritt des zweiten Kontaktelements in die Durchführung im Isolierstoffformkörper. Der dritte Kontaktabschnitt definiert sich als der der externen Leiterplatte zugewandte Abschnitt ab dem Austritt des zweiten Kontaktelements aus der Durchführung im Isolierstoffformkörper.

Die schaltungsgerechte Verbindung des dritten Kontaktabschnittes des zweiten Kontaktelements mit der externen Leiterplatte erfolgt gemäß dem Stand der Technik bevorzugt mittels Durchstecklötmontage, kann jedoch uneingeschränkt ebenso mittels Oberflächenlötmontage erfolgen

Die Druckkontaktierung der Anordnung erfolgt bevorzugt mittels einer Schraub-, Niet-, oder Schnapp-Rast-Verbindung zwischen dem Gehäuse und der Verbindungseinrichtung. Darüber hinaus kann beispielhaft zusätzlich die externe Leiterplatte mittels der Schraub- oder Schnapp-Rast-Verbindung mit der Verbindungseinrichtung verbunden werden. Hierdurch entsteht eine kraftschlüssige, zuverlässige und reversible elektrische Verbindung zwischen dem Leistungshalbleitermodul und der Verbindungseinrichtung zur Kontaktierung mit einer externen Leiterplatte.

Erfindungsgemäß ist beispielhaft das erste Kontaktelement in seinem ersten Kontaktabschnitt federnd ausgebildet. Ebenso kann es alternativ oder zusätzlich vorteilhaft sein, das zweite Kontaktelement in seinem zweiten Kontaktabschnitt federnd auszubilden. Hierbei kann es bevorzugt sein, zum Schutz der Kontaktelemente gegen die durch die Druckkontaktierung und den Betrieb auftretenden mechanischen Stress- und Wärmebelastung zwischen dem jeweiligen Kontaktabschnitt und dem ihm jeweils zugeordnetem Widerlager ein elastisches Kissenelement anzuordnen.

Die erfinderische Lösung wird an Hand der Ausführungsbeispiele der Fig. 1 bis 4 weiter erläutert.

Fig. 1 zeigt eine Anordnung gemäß dem Stand der Technik im Querschnitt sowie eine vergrößerte Ansicht eines Bereiches im Querschnitt.

Fig. 2 zeigt in einem Ausschnitt eine erste Ausgestaltung einer erfindungsgemäßen Anordnung im Querschnitt.

Fig. 3 zeigt in einem Ausschnitt eine zweite Ausgestaltung einer erfindungsgemäßen Anordnung im Querschnitt.

Fig. 4 und 5 zeigen jeweils in einem Ausschnitt weitere Ausgestaltungen einer erfindungsgemäßen Anordnung im Querschnitt mit einem federnd ausgestalteten Kontaktelement.

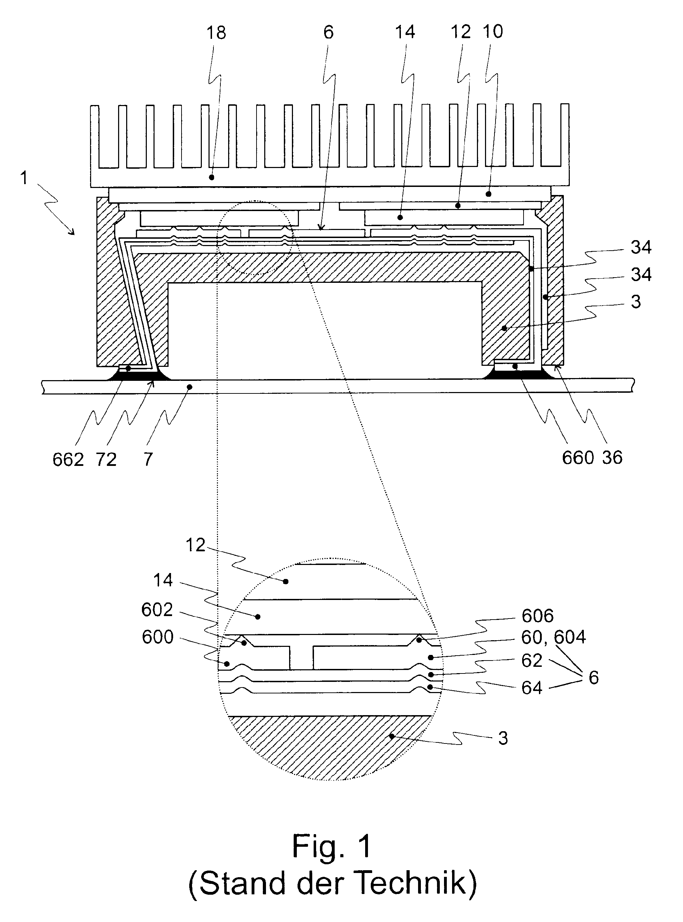

Fig. 1 zeigt eine Ausgestaltung einer Anordnung gemäß dem Stand der Technik mit einem Leistungshalbleitermodul (1), mit einer Verbindungseinrichtung (2) und einer externen Leiterplatte (7). Zwecks der Anschaulichkeit des Aufbaus ist weiterhin ein Kühlkörper (18) dargestellt.
Das Leistungshalbleitermodul besteht aus einem Gehäuse (3), welches ein elektrisch isolierendes Substrat (10) umschließt. Dieses wiederum weist einen Grundkörper, vorzugsweise eine Isolierkeramik wie Aluminiumoxid oder Aluminiumnitrit auf. Auf der dem Inneren des Leistungshalbleitermoduls zugewandten ersten Hauptfläche weist das Substrat (10) in sich strukturierte Leiterbahnen (12) auf. Auf den Leiterbahnen (12) des Substrats sind Leistungshalbleiterbauelemente (14) angeordnet und schaltungsgerecht mittels eines ersten Kontaktelements (6) verbunden, welches aus einer alternierenden Schichtfolge gebildet wird. Dieser Schichtfolge, detailliert dargestellt im vergrößerten Ausschnitt zur Fig. 1, wird gebildet aus einer ersten (60) und einer zweiten (64) leitenden jeweils in sich strukturierten und somit Leiterbahnen ausbildenden Schicht und einer dazwischen angeordneten isolierenden Schicht (62). Hierbei kontaktiert die erste leitende Schicht (60) die Leistungshalbleiterbauelemente schaltgerecht (14) mittels Punktschweißverbindungen (602, 606). Weiterhin führt das Kontaktelement durch Führungsabschnitte (34) im Gehäuse (3) an dessen Außenseite (36), wo es entsprechend ausgestaltete Kontaktabschnitte (660, 662) zur Last- und Steuerkontaktierung (72) mit einer externen Leiterplatte (7) aufweist, welche mittels einer Lötverbindung ausgebildet sind,

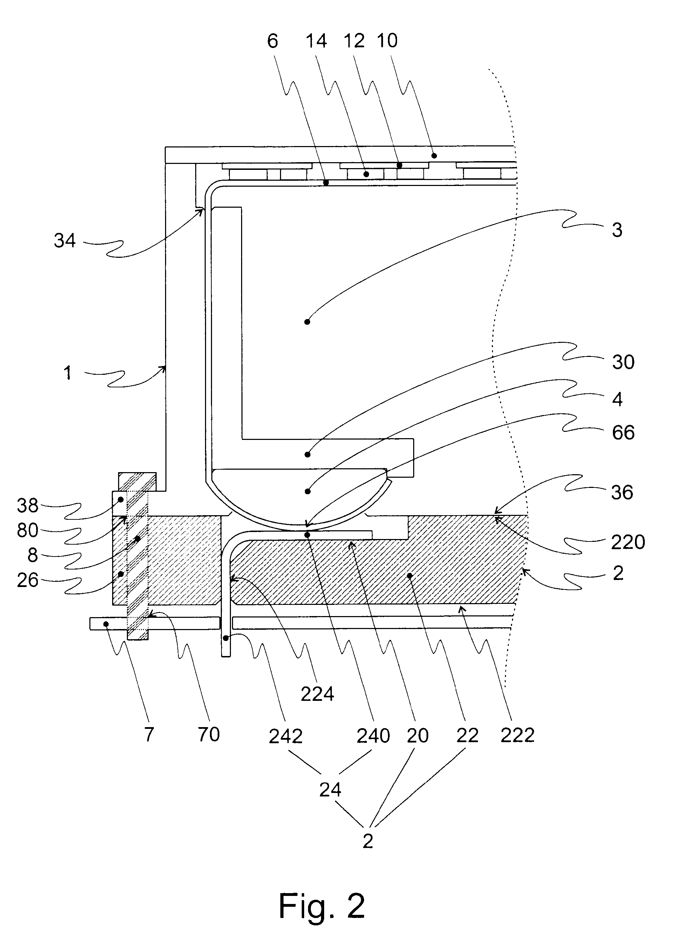

Fig. 2 zeigt einen Ausschnitt einer erste Ausgestaltung einer erfindungsgemäßen Anordnung mit einem Leistungshalbleitermodul im Querschnitt, wobei baugleiche Elemente zu Fig. 1 nicht extra beschrieben werden.
Dargestellt ist die linke Seite des Leistungshalbleitermoduls (1) im Querschnitt mit dem beschriebenen Kontaktelement (6), welches aus dem Inneren des Gehäuses durch einen ersten Führungsabschnitt (34) im Gehäuse (3) an eine Außerseite (36) des Gehäuses reicht und an dieser Außenseite (36) einen bogenförmigen und dadurch federnd ausgestalteten Kontaktabschnitt (66) ausbildet. Weiterhin ist dem ersten Kontaktabschnitt an dem Gehäuse ein Widerlager zugeordnet, welches einstückig aus einem Teil des Gehäuses ausgebildet ist. Zwischen Widerlager und dem ersten Kontaktabschnitt befindet sich weiterhin ein elastisches Kissenelement (66), welches der Aufrechterhaltung der auf das erste Kontaktelement wirkenden Federkräfte bei der Druckkontaktierung dient.

Weiterhin dargestellt ist eine Verbindungseinrichtung (2), die einen Isolierstoffformkörper (22) und ein zweites Kontaktelement (24) aufweist, welches hier bandartig ausgestaltet ist und parallel zu der ersten Hauptfläche (220) des Isolierstoffkörpers einen zweiten Kontaktabschnitt (240) zur Kontaktierung mit dem Kontaktelement (6) des Leistungshalbleitermoduls (1) ausbildet. Weiterhin reicht das zweite Kontaktelement durch einen zweiten Führungsabschnitt (224) im Isolierstoffkörper an die zweite Hauptfläche (222) und bildet dort einen dritten Kontaktabschnitt (242) zur Kontaktierung mit der externen Leiterplatte (7) aus.

Die Druckbeaufschlagung zur kraftschlüssigen Verbindung der Verbindungseinrichtung (2) mit dem Leistungshalbleitermodul (1) erfolgt mittels Schraubverbindung. Hierbei weist das Gehäuse (3) des Leistungshalbleitermoduls einen ersten freigestellten, einstückig ausgebildeten Materialabschnitt (38) zur Aufnahme einer Schraubverbindung (8) auf, welcher fluchtend zur Außenseite (36) des Gehäuses ausgebildet ist. Ebenso weist die Verbindungseinrichtung (2) einen zweiten freigestellten, einstückig ausgebildeten Materialabschnitt (26) auf, welcher fluchtend zur ersten Hauptseite (220) der Verbindungseinrichtung ausgebildet und dem ersten Materialabschnitt (38) entsprechend zugeordnet ist. Beide Materialabschnitte weisen eine zueinander fluchtende Aussparung (80) auf, die zur Aufnahme der Schraubverbindung dient. Zusätzlich dient eine entsprechend zugeordnete weitere Aussparung (70) in der externen Leiterplatte (7) zur Montage der Leiterplatte an der erfindungsgemäßen Anordnung.

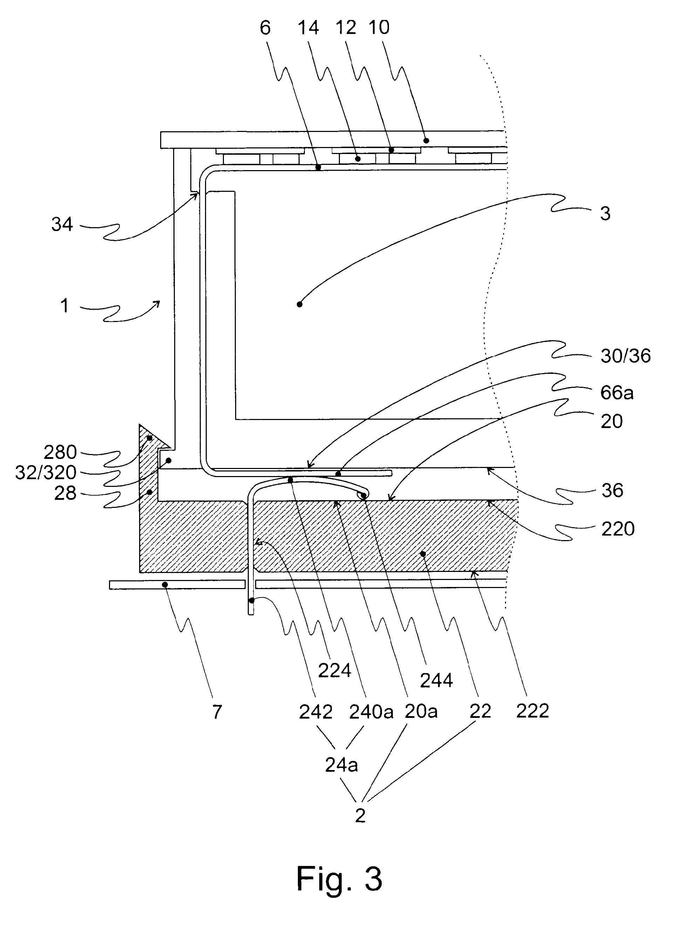

Fig. 3 zeigt einen Ausschnitt einer weiteren Ausgestaltung einer erfindungsgemäßen Anordnung im Querschnitt, wobei wiederum baugleiche Elemente nicht extra beschrieben werden. Die Außenseite (36) des Gehäuses (3) bildet hierbei zugleich das dem ersten Kontaktabschnitt (66a) zugeordnete Widerlager (30), jedoch ohne Kissenelement. Das zweite Kontaktelement (24a) der Verbindungseinrichtung ist hierbei bandartig und in seinem zweiten Kontaktabschnitt bogenförmig um somit federnd ausgestaltet, indem das Endstück (244) des zweiten Kontaktabschnittes (240a) des bandartigen Kontaktelements am zugeordneten zweiten Widerlager (20a) anliegt und die konvexe Krümmung des zweiten Kontaktabschnitts bei Druckbeaufschlagung eine Federwirkung ermöglicht.

Die Druckbeaufschlagung zur kraftschlüssigen Verbindung mit dem Leistungshalbleitermodul erfolgt mittels Schnapp-Rastverbindung. Hierbei weist die Verbindungseinrichtung einen freigestellten, beweglich ausgebildeten Materialabschnitt (28) auf, welcher eine Rasteinrichtung (280) ausbildet. Entsprechend weist das Gehäuse (3) des Leistungshalbleitermoduls einen freigestellten, starr ausgebildeten Materialabschnitt (32) auf, welcher als Rastwiderlager (320) dient.

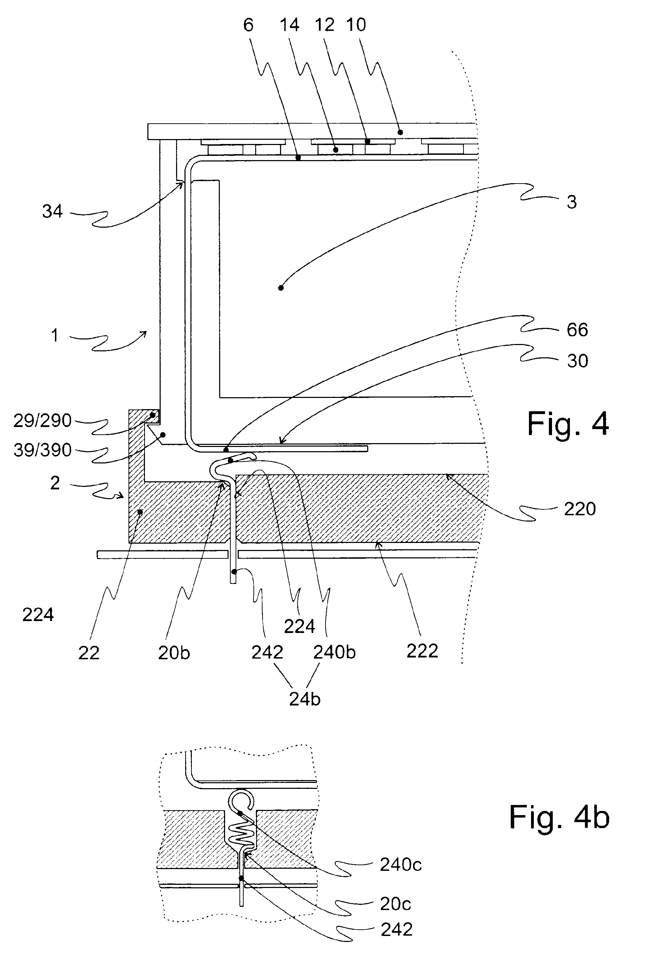

Fig. 4 zeigt einen Ausschnitt einer weiteren Ausgestaltung einer erfindungsgemäßen Anordnung. Hierbei ist das zweite Kontaktelement (24b) der Verbindungseinrichtung drahtartig und in seinem zweiten Kontaktabschnitt (240b) hakenförmig ausgebildet, indem der zweite Kontaktabschnitt eine gegenläufige Doppelbiegung aufweist und das ihm zugeordnete zweite Widerlager (20b) hierbei die ihm zugewandte Biegung abstützt.

Fig. 5 zeigt in einem Ausschnitt eine weitere Ausgestaltung des zweiten Kontaktelements (24c), welches hier drahtförmig und spiralfederartig durch entsprechende Wendelungen ausgebildet ist und der zweite Kontaktabschnitt (240c) an der ersten Wendelung durch das ihm zugeordnete Widerlager (20c) gestützt wird.

## Patentansprüche

1. Anordnung in Druckkontaktierung mit einem Leistungshalbleitermodul (1) und mit einer Verbindungseinrichtung (2), wobei das Leistungshalbleitermodul ein Gehäuse (3) und ein erstes Kontaktelement (6) und ein ihm zugeordnetes ersten Widerlager (30) aufweist,
wobei das erste Kontaktelement (6) aus einer alternierenden Schichtfolge mindestens einer elektrisch leitenden, in sich strukturierten und somit Leiterbahnen ausbildenden Schicht (60, 64) und mindestens einer elektrisch isolierenden Schicht (62) ausgestaltet ist und mindestens einen ersten, aus einer an einer Außenseite (36) des Gehäuses angeordneten Durchführung (34) im Gehäuse reichenden Kontaktabschnitt (66) zur Kontaktierung mit der Verbindungseinrichtung (2) aufweist,
wobei die Verbindungseinrichtung (2) einen Isolierstoffformkörper (22), mindestens ein zweites Kontaktelement (24) und ein ihm zugeordnetes zweites Widerlager (20) aufweist,
wobei das dem Isolierstoffformkörper (22) zugeordnete mindestens eine zweite Kontaktelement einen zweiten Kontaktabschnitt (240) zur Kontaktierung mit dem ersten Kontaktabschnitt des ersten Kontaktelements und einen dritten (242) Kontaktabschnitt zur Kontaktierung mit einer externen Leiterplatte (7) aufweist und und wobei mindestens ein Kontaktabschnitt gegenüber dem ihm zugeordneten Widerlager federnd ausgestaltet ist.

2. Anordnung nach Anspruch 1,
wobei zwischen dem Kontaktabschnitt (66, 240) des jeweils federnd ausgestalteten Kontaktelements (6, 24) und dem ihm zugeordneten ersten Widerlager (30, 20) ein elastisches Kissenelement (4) angeordnet ist

3. Anordnung nach Anspruch 1,
wobei der federnd ausgebildete erste oder zweite Kontaktabschnitt bogen- (66, 240a), haken- (240b) oder spiralförmig (240c) ausgestaltet ist.

4. Anordnung nach Anspruch 1,
wobei die Verbindungseinrichtung (2) mindestens einen ersten freigestellten Abschnitt (26) und das Gehäuse (3) mindestens einen ersten, entsprechend zugeordneten freigestellten Abschnitt (38) aufweist, und wobei beide Abschnitte (26, 38) zueinander fluchtende Aussparungen (80) zur Durchführung einer Schraubverbindung (8) aufweisen.

5. Anordnung nach Anspruch 1,
wobei der Isolierstoffformkörper (22) der Verbindungseinrichtung (2) einen zweiten freigestellten beweglichen Abschnitt (28) mit einer Rasteinrichtung (280) und das Gehäuse (3) einen zweiten freigestellten Abschnitt (32) mit einer der Rasteinrichtung zugeordneten Rastwiderlager (320) aufweist oder wobei das Gehäuse (3) einen zweiten freigestellten beweglichen Abschnitt (39) mit einer Rasteinrichtung (390) und der Isolierstoffformkörper (22) der Verbindungseinrichtung (2) einen zweiten freigestellten Abschnitt (29) mit einer der Rasteinrichtung zugeordneten Rastwiderlager (290) aufweist.
